# EUROPEAN PATENT SPECIFICATION

(11) **EP 1 788 634 B1**
(45) Date of publication and mention of the grant of the patent: **19.05.2010**
(21) Application number: 05110828.0
(22) Date of filing: 16.11.2005
(51) Int. Cl.: H01L 29/778, H01L 29/423

(54) **Field effect transistor and method for manufactoring the same**
Feldeffekttransistor und Verfahren zur Herstellung
Transistor à effet de champ et procédé pour sa fabrication.

(43) Date of publication of application: 23.05.2007
(73) Proprietor: Forschungsverbund Berlin e.V., 12489 Berlin (DE)
(72) Inventor: Lossy, Richard, 14197, Berlin (DE)
(74) Representative: Hengelhaupt, Jürgen

(56) References cited:
- US-A1- 2001 052 651
- US-A1- 2005 051 800
- CHINI A ET AL: "POWER AND LINEARITY CHARACTERSTICS OF FIELD-PLATED RECESSED-GATE ALGAN-GAN HEMTS" IEEE ELECTRON DEVICE LETTERS, IEEE SERVICE CENTER, NEW YORK, NY, US, vol. 25, no. 5, May 2004 (2004-05), pages 229-231, XP001193192 ISSN: 0741-3106
- WOODHAM R G: "R-GATE, R-GATE, AND AIR-BRIDGE FABRICATION FOR MONOLITHIC MICROWAVE INTEGRATED CIRCUITS BY MIXED ION-BEAM, HIGH-VOLTAGE ELECTRON- BEAM, AND OPTICAL LITHOGRAPHY" JOURNAL OF VACUUM SCIENCE AND TECHNOLOGY: PART B, AVS / AIP, MELVILLE, NEW YORK, NY, US, vol. 10, no. 6, 1 November 1992 (1992-11-01), pages 2927-2931, XP000332500 ISSN: 1071-1023

## Description

### FIELD OF THE INVENTION

The present invention relates to a field effect transistor and more particularly to High-Electron-Mobility-Transistors (HEMT) based on aluminium-gallium-nitride and gallium-nitride (AlGaN/GaN) having a novel gate electrode concept for improving the characteristics under high power and high voltage operation at microwave or millimeter wave frequencies.

### BACKGROUND OF THE INVENTION

A conventional field effect transistor (HEMT, MESFET) includes a semiconductor substrate with conductive layers or insulating layers disposed on the substrate (i.e. epitaxial). A gate electrode is provided to modulate the current flowing through a channel from a source electrode to a drain electrode. Most commonly, the gate is fed from one end with the radio-frequency-modulating signal.

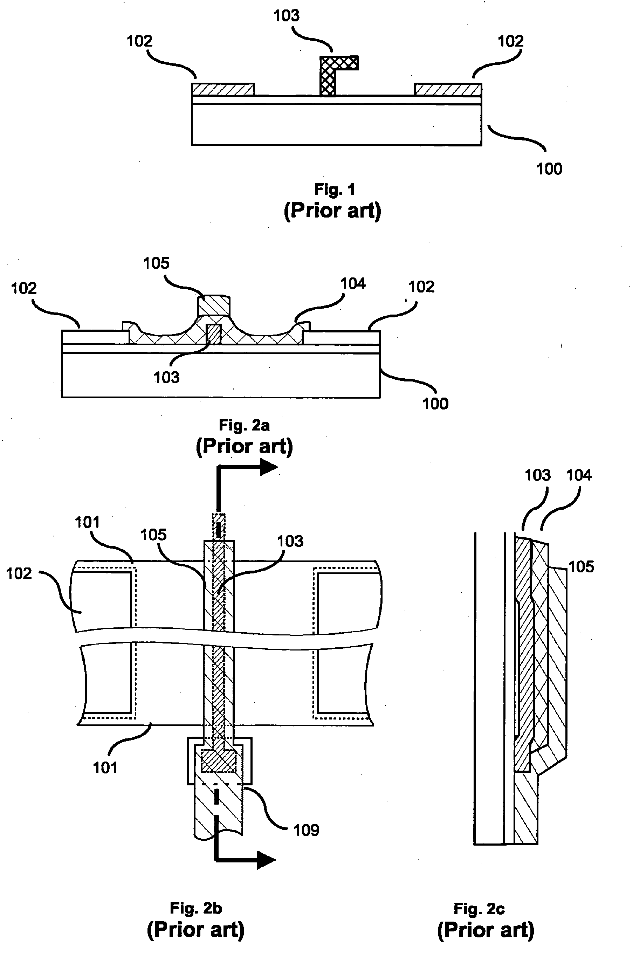

One means for providing higher voltage operation is the use of a field-plate in direct connection with the gate structure. Typically, such a field-plate is fabricated in conjunction with the gate structure and fixed to the same on the top side thus forming a Γ-shaped gate profile. An example of such a transistor with Γ-shaped gate is shown in Fig.1 and found in Journal Vacuum Science and Technology B Nov 1992 p.2927-2931, "T-gate, Γ-gate, and air-bridge fabrication for monolithic microwave integrated circuits". In such design the size and distance of the field-plate to the semiconductor surface is limited due to constraints of the manufacturing process.

Another means for the design of a gate with field-plate has a separate field-plate that is electrically connected to the gate only at the feeding location. An example of such a transistor with field-plate structure is shown in Fig.2 and found in IEEE Electron Device Letters, EDL-25, No.5, May 2004, 229-231, "Power and Linearity Characteristics of Field-Plated Recessed-Gate AlGaN-GaN HEMTs". In such article a single ended field-plate structure 105 is formed over the gate-line 103. Both are separated by a silicon-nitride passivation layer 104. The purpose of this structure is enhancement in radio frequency (RF) current-voltage swing which can be achieved through both reduction in the trapping effect and increase in breakdown voltage. This type of field-plate design is suitable only for relatively small transistor finger width and large gate length. In this article gate-finger is 75µm wide and gate length is 0.7µm.

Efficient use of chip area for power transistors not only requires the use of many transistor fingers which are connected in parallel but also the width of the individual transistor fingers should be enlarged as much as possible. The gate width of power transistors is restricted to a useful limit when losses imposed by the gate metal result in a loss of power density (i.e. power per gate width).

Also, for power microwave transistors not only large periphery is required but high gain operation is highly desirable allowing more efficient amplifier design, higher bandwidth and better linearity. There exists a trade-off between gain of a transistor, which is related to gate length, and power loss due to the limited dimensions of the current carrying cross-section of the gate metal. Due to these limitations a T-gate transistor having 0.3µm gate length shows a reduction of power density for transistor fingers having a width exceeding 250µm when operated at 2GHz.

US 2001/052651 A1 discloses a MOSFET having a gate shunt

US 2005/0051800 A1 deals with a multi-stage amplifier which combines transistors having field-plates with transistors without field-plates.

### OBJECT OF THE INVENTION

Therefore it is an object of the invention to improve the gain of a field effect transistor while minimising the power loss due to the limited dimensions of the current carrying cross-section of the gate metal at the same time.

### SUMMARY OF THE INVENTION

The present invention is directed to a field effect transistor as set forth in claim 1.

Preferably a passivation layer is arranged on the gate electrode and the feed-plate is arranged on the passivation layer in the area over the gate electrode and the passivation layer comprises at least two openings wherein the gate electrode contacts the feed-plate through the opening. Preferably the feed-plate is formed of gold. Preferably the feed-plate is formed of a material having a thickness of more than 1µm. Preferably the passivation layer comprises a plurality of openings. Preferably the openings are arranged in equal distance to each other and/or the openings comprise a surface area between 1 µm² and 50 µm², preferably between 5 µm² and 15 µm²and more preferably between 8 µm² and 10 µm². Preferably the openings comprise a rectangular shape. Preferably the gate electrode comprises a gate length between 0,15 µm and 0,7 µm and a gate width of more that 250 µm, more preferably a length between 0,2 µm and 0,5 µm and a width of more that 350 µm, and still more preferably a width of more that 450 µm. Preferably the field effect transistor comprises a plurality of segmented transistor fingers arranged to form an array, each transistor finger comprising separate mesa regions, separate source contacts and separate drain contacts, the source contacts and the drain contacts of the transistor fingers being electrically connected a source/drain-connection line. Preferably the openings are located in the area between the mesa regions. Preferably the passivation layer has a thickness of more than 200 nm to provide low gate-drain capacitance. Preferably the gate electrodes of consecutive finger segments are connected by intermediate pads between the mesa region on insulating substrate area. The feed-plate comprises one end which is connected or connectable to a power source.

Furthermore, the present invention is directed to a method for manufacturing a field effect transistor of the first inventive aspect as set forth in claim 15.

The gate electrode preferably comprises a rectangular shape or T-shape using a Schottky-contact metal and gold. The feed-plate is preferably formed as a top metal line parallel to the gate electrode line that acts as a feed-line or gate-shunt and in addition as a field-plate. Due to the fact that the top metal line has a new functionality as it acts both as a feed-line and a field-plate it will be designated as feed-plate.

The feed-plate and gate are connected repeatedly along the line by openings in the passivation layer. The connecting areas (openings) between the gate and the feed-plate are situated outside the mesa area of the HEMT structure in order to allow high electric field on the drain side of the gate and short gate-length in the active area and providing sufficient area for contacting the two lines.

For power transistors a segmented gate structure is preferably used.

### BRIEF DESCRIPTION OF THE DRAWINGS

The foregoing and additional advantages of the present invention will become apparent from the detailed description and accompanying drawing figures below. In the figures and written description reference numbers indicate the various elements of the invention. The figures show:
- Fig 1: a sectional view of a conventional r-gate structure,
- Fig 2a: a sectional view of a conventional single ended field plate gate structure,
- Fig 2b: a plan view of conventional single ended field plate gate structure,
- Fig 2c: a sectional side view of conventional single ended field plate gate structure,
- Fig 3a: a sectional view of a segmented single-finger transistor according to a first embodiment of the present invention,
- Fig 3b: a plan view of a segmented single-finger transistor according to the first embodiment of the present invention,
- Fig 3c: a sectional side view of a segmented single-finger transistor according to the first embodiment of the present invention,
- Fig 4: a plan view of a segmented multi-finger power transistor according to a second embodiment of the present invention,
- Fig 5: a sectional view of a single-finger transistor with double insulating layers according to a third embodiment of the present invention, and
- Fig 6: a graph diagram showing output power and gain of transistor cells comprising of 8 gate-fingers and gate width ranging from 125µm to 500µm.

### DETAILED DESCRIPTION OF PREFERRED EMBODIMENTS

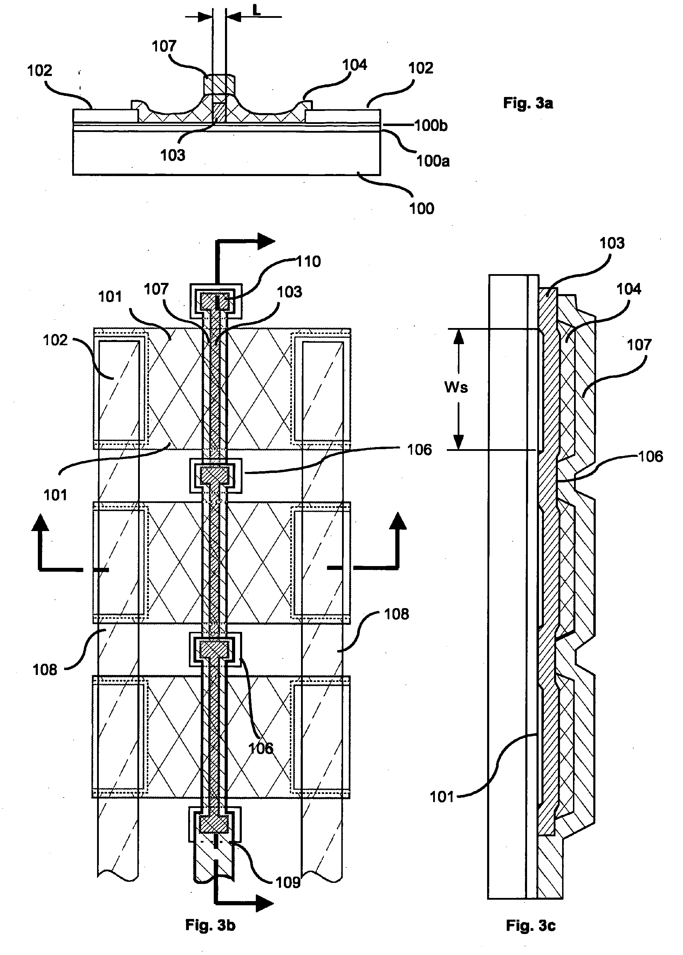

As illustrated in Fig. 3 the present invention provides a HEMT. It comprises a substrate 100 that can be either sapphire (Al₂O₃) or silicon carbide (SiC), with the preferred substrate being a 4H polytype of silicon carbide for power transistor applications.

The HEMT is formed from a multiplicity of epitaxial layers on the aforementioned substrates 100 and comprises a gallium nitride (GaN) channel layer 100a and an aluminium gallium nitride (AlGaN) barrier layer 100b on the channel layer 100a. Doping from silicon atoms may be provided for part of the barrier layer 100b.

The active transistor area including the three transistor electrodes (gate, drain, source) is located on the mesa area 101. In this mesa area 101 the two semiconducting layers 100a, 100b are arranged thereby generating a 2-dimensional electron channel (2DEG) at their interface. The electrons move from source to drain and will be controlled by the gate. Outside of the mesa area 101 the semiconducting material is functioning as a isolating layer - the manufacture of the non conducting characteristics is usually carried out by etching which leads to the removal of the upper semiconducting layer (preferably AlGaN). Hence the electron channel (2DEG) does not exist without the AlGaN-layer outside of the mesa area 101. The transistor fingers are divided into segments, the segments comprising mesa areas 101 whereby insulating area are arranged between the mesa areas 101 of the respective transistor fingers. According to the invention it is preferred that the electrical connection between gate 103 and feed plate 107 is carried out in the area of the above-mentioned insulating areas.

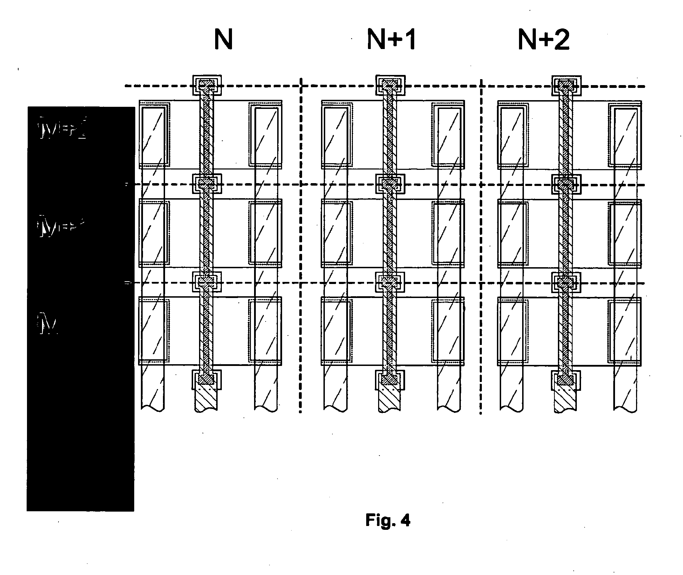

The power transistor is made up by a multiplicity of active transistor segments arranged to form an array (Fig.4). Transistor segments are fabricated from rectangular mesa areas 101 by the aid of BCl₃-Cl₂ dry etching process. Active transistor segments on the mesa area are separated by insulating areas provided by dry-etching process.

Transistor segments are connected at drain 102, source 102 and gate contacts 103 to form gate fingers (Fig. 3a and 3b). Transistor cells are formed by a multiplicity of gate-fingers (Fig. 4). The total gate-width W of the power transistor is the sum of all segments gate-width Ws of Fig. 3c.

A first ohmic contact is disposed on the top surface to provide a source electrode 102 and a second ohmic contact is also disposed on the top surface and is spaced apart from the source electrode to provide a drain electrode 102.

A non-ohmic or Schottky contact is disposed on the top surface to provide a gate contact. The gate line 103 consists of a high work-function metal, preferably platinum or nickel, and gold to provide a low access resistance. The gate line 103 is placed between drain and source contact 102 and its cross-section may be either rectangular or T-shaped. The gate line 103 is divided in sections and every section is terminated by a pad area on insulating semiconductor 100a outside the mesa area 101. Placing the pad area outside the active transistor area 101 avoids high electric fields at the pad corners that otherwise might compromise the breakdown behavior of the transistor device.

The gate structure and the transistor channel are covered by a passivating layer 104 preferably silicon-nitride or any combination of passivating material. This passivation layer 104 also serves as a mechanical support for the feed-plate-structure 107. Outside the mesa area 101 at the locations of the outer and intermediate gate-pads the passivating layers 104 are fully removed thereby resulting in the openings 106. The layer 104 is preferably structured by lithographic techniques and reactive ion etching.

The feed-plate structure 107 is located above the gate-line 103 at a distance according to the total thickness of the passivation layers 104. On each of the openings 106 in the passivation layer 104 a connection is provided from the feed-plate 107 to the gate-pads of gate line 103. The purpose of the feed-plate 107 is twofold:
The gate-length L , as defined in Fig. 3a, observes an inverse relation to the maximum frequency of operation and to the high frequency gain. Therefore, the total dimension available for current-flow in the gate 103 is rather limited for high frequency operation. Hence, for high power transistors, which require rather extended gate-fingers to achieve the necessary total gate-width W, a trade-off exists between maximum frequency of operation and loss from gate access resistance. The feed-plate 107 provides a shunt for the gate access due to its multiple access points. Access resistance and inductance of the feed-plate 107 are considerably lower compared to the gate 103 as the dimensions are not limited by the aforementioned trade-offs.

Second, surface traps, acting as a virtual gate in the gate-drain access region, prevent proper device operation, reducing the available current swing as well as degrading the knee-voltage. Using a proper designed feed-plate 107, a reduction of electric field at the gate edge directed towards the drain electrode 102 is achieved. This leads to lower electron injection in surface state traps and less modulation of surface state traps in the gate-drain access region. As a result, full voltage swing and higher RF-power are obtained.

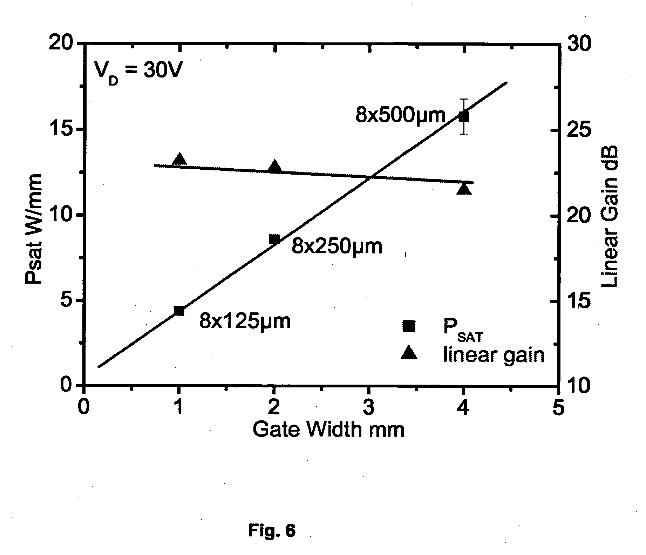

Introducing the feed-plate design solves problems associated with losses from insufficient gate access and current compression on large periphery microwave transistors and devices with a gate finger width of at least 500µm reveal no onset of power density degradation (documented in Fig.6).

The feed-plate 107 is arranged in parallel to the gate structure 103 and does not cross the source contacts 102. Therefore, the additional gate-source-capacitance is negligible compared to the regular capacitance originating from the Schottky gate contact. The feed-plate structure provides additional degree of freedom for the dimensions and distance of the feed-plate 107 to the current carrying layer. It enables minimum gate-drain-capacitance, thus reducing feed-back phenomena known from power transistors like odd-mode oscillations. Maximum gate-signal supply is achieved from the feed-plate 107 up to the end of the gate contact 103 using proper size of the current carrying area. The reduced field-strength in the vicinity of the gate electrode minimizes current compression phenomena thus allowing higher voltage operation.

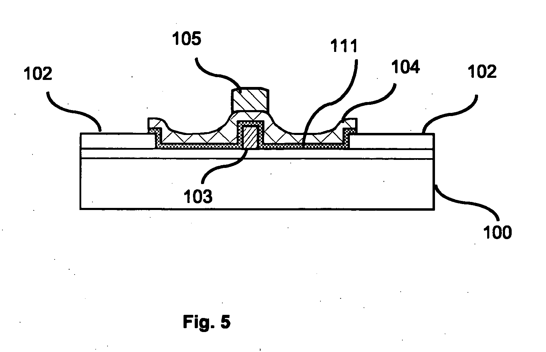

Fig. 5 shows a sectional view of a single-finger transistor with an additional passivation layer 111 (beneath passivation layer 104) according to a third embodiment of the present invention.

In the above-illustrated embodiment a high electron mobility transistor (HEMT) is described, but the present invention is not restricted thereto and may be applied to all control electrode structures 103 of a field effect transistor which includes FET, HFET, MESFET, TEGFET, and MODFET devices, and any binary ternary and quaternary components which are used to built the FET devices using the elements silicon (Si), germanium (Ge), gallium (Ga), arsenic (As), aluminium (Al), indium (In), antimonide (Sb), phosphorus (P), nitrogen (N) and carbon (C).

### List of Reference Signs

- 100: Substrate
- 100a: GaN semiconductor layer
- 100b: AlGaN semiconductor layer
- 101: Mesa area
- 102: Source or drain contact
- 103: Gate electrode
- 104: Passivation layer
- 105: Field plate
- 106: Opening in passivation layer
- 107: Feed-plate
- 108: Source/Drain-connection line
- 109: First gate end and power supply
- 110: Second gate end
- 111: Additional passivation layer

- L: Gate length of the gate electrode
- Ws: Gate-width of single finger segment
- W: Total gate-width

## Claims

1. A field effect transistor comprising:
a substrate (100), a semiconductor layer (100b), a source contact (102) and a drain contact (102); the semiconductor layer (100b) being arranged on the substrate (100), the source contact (102) and the drain contact (102) being arranged on the semiconductor layer (100b); and a gate electrode (103) being arranged on the semiconductor layer (100b) in an area which is located between the source contact (102) and the drain contact (102), the gate electrode (103) comprising a longish shape and having a first end (109) for contacting a power source and a second end (110),
**characterised by** a feed-plate (107) electrically connected to the gate electrode (103), the feed-plate (107) contacting the gate electrode (103) in a region between the first end (109) and the second end (110) and protruding over the edge of the gate electrode (103) toward the drain contact (102), wherein the feed-plate (107) is adapted to both act as a feed-line and as a field-plate.

2. The field effect transistor according to claim 1, wherein the semiconductor layer (100b) is a doped semiconductor layer or the field effect transistor comprises at least a first undoped semiconductor layer (100a) and a second doped semiconductor layer (100b).

3. The field effect transistor according to claim 2, wherein the first semiconductor layer (100a) comprises GaN and the second semiconductor layer (100b) comprises AlGaN.

4. The field effect transistor according to claim 1, wherein a passivation layer (104) is arranged on the gate electrode (103) and the feed-plate (107) is arranged on the passivation layer (104) in the area over the gate electrode (103) and the passivation layer (104) comprises at least two openings (106) wherein the gate electrode (103) contacts the feed-plate (107) through the opening (106).

5. The field effect transistor according to one of the preceding claims, wherein the feed-plate (107) is formed of gold.

6. The field effect transistor according to one of the preceding claims, wherein the feed-plate (107) is formed of a material having a thickness of at least 0,5µm and preferably more than 1µm.

7. The field effect transistor according to one of the preceding claims, wherein the passivation layer (104) comprises a plurality of openings (106).

8. The field effect transistor according to claim 4 or to claim 4 and one of the claims 5 to 7, wherein the openings (106) are arranged in equal distance to each other and/or the openings comprise a surface area between 1 µm²and 50 µm², preferably between 5 µm² and 15 µm².

9. The field effect transistor according to claim 4 or to claim 4 and one of the claims 5 to 8, wherein the openings (106) comprise a rectangular shape.

10. The field effect transistor according to one of the preceding claims, wherein the gate electrode (103) comprises a gate length (L) between 0,15 µm and 0,7 µm and a gate width (W) of more that 400 µm.

11. The field effect transistor according to one of the preceding claims, wherein the field effect transistor comprises a plurality of segmented transistor fingers arranged to form an array, each transistor finger comprising one or more separate mesa regions (101), one or more separate source contacts (102) and one or more separate drain contacts (102), the source contacts (102) and the drain contacts (102) of the transistor fingers being electrically connected from a source/drain-connection line (108).

12. The field effect transistor according to claims 4 and 11, wherein the openings (106) are located in the area between the mesa regions (101).

13. The field effect transistor according to claim 4 or to claim 4 and one of claims 5 to 12,
wherein the passivation layer (104) has a thickness of more than 200 nm to provide low gate-drain capacitance and low gate-drain coupling.

14. The field effect transistor according to one of claims 11 to 12 or to claim 11 and one of the claims 12 to 13, wherein the gate electrodes (103) of consecutive finger segments are connected by intermediate pads between the mesa regions (101)of the consecutive finger segments on insulating substrate area (100).

15. A method for manufacturing a field effect transistor comprising:
providing a substrate (100),
application of a semiconductor layer (100b), a source contact (102) and a drain contact (102);
application of a longish gate electrode (103) on the semiconductor layer (100b) in an area which is located between the source contact (102) and the drain contact (102), the gate electrode (103) having a first end (109) for contacting a power source and a second end (110) ;
wherein the gate electrode (103) is electrically connected to a feed-plate (107) in a region between the first end (109) and the second end (110), the feed-plate (107) protruding over the edge of the gate electrode (103) toward the drain contact (102) and being adapted to both act as a feed-line and as a field-plate.

16. The method according claim 15, wherein a passivation layer (104) is formed between the semiconductor layer (100b) and the feed-plate (107).

17. The method according claim 16, wherein one or more additional passivation layer(111) are applied on the gate contact (103) between the semiconductor layer (100b) and the passivation layer (104).

## Patentansprüche

1. Feldeffekttransistor, umfassend:
ein Substrat (100), eine Halbleiterschicht (100b), einen Source-Anschluss (102) und
einen Drain-Anschluss (102), wobei die Halbleiterschicht (100b) auf dem Substrat (100) angeordnet ist, der Source-Anschluss (102) und der Drain-Anschluss (102) auf der Halbleiterschicht (100b) angeordnet sind und eine Gate-Elektrode (103) in einem zwischen dem Source-Anschluss (102) und dem Drain-Anschluss (102) befindlichen Bereich auf der Halbleiterschicht (100b) angeordnet ist, wobei die Gate-Elektrode (103) eine längliche Form aufweist und ein erstes Ende (109) zum Kontaktieren einer Energiequelle und ein zweites Ende (110) aufweist,
**gekennzeichnet durch** eine Feed-plate (107), die mit der Gate-Elektrode (103) elektrisch verbunden ist, wobei die Feed-plate (107) die Gate-Elektrode (103) in einem Bereich zwischen dem ersten Ende (109) und dem zweiten Ende (110) kontaktiert und über den Rand der Gate-Elektrode (103) in Richtung des Drain-Anschlusses (102) übersteht, wobei die Feed-plate (107) so angepasst ist, dass sie sowohl als Feed-line als auch als Field-plate fungiert.

2. Feldeffekttransistor nach Anspruch 1, wobei die Halbleiterschicht (100b) eine dotierte Halbleiterschicht ist oder der Feldeffekttransistor zumindest eine erste undotierte Halbleiterschicht (100a) und eine zweite dotierte Halbleiterschicht (100b) umfasst.

3. Feldeffekttransistor nach Anspruch 2, wobei die erste Halbleiterschicht (100a) GaN umfasst und die zweite Halbleiterschicht (100b) AIGaN umfasst.

4. Feldeffekttransistor nach Anspruch 1, wobei auf der Gate-Elektrode (103) eine Passivierungsschicht (104) angeordnet ist und die Feed-plate (107) im Bereich über der Gate-Elektrode (103) auf der Passivierungsschicht (104) angeordnet ist und die Passivierungsschicht (104) mindestens zwei Öffnungen (106) umfasst, wobei die Gate-Elektrode (103) die Feed-plate (107) durch die Öffnung (106) kontaktiert.

5. Feldeffekttransistor nach einem der vorangehenden Ansprüche, wobei die Feed-plate (107) aus Gold ausgebildet ist.

6. Feldeffekttransistor nach einem der vorangehenden Ansprüche, wobei die Feed-plate (107) aus einem Material mit einer Dicke von mindestens 0,5 µm und vorzugsweise über 1 µm ausgebildet ist.

7. Feldeffekttransistor nach einem der vorangehenden Ansprüche, wobei die Passivierungsschicht (104) eine Mehrzahl von Öffnungen (106) umfasst.

8. Feldeffekttransistor nach Anspruch 4 oder nach Anspruch 4 und einem der Ansprüche 5 bis 7, wobei die Öffnungen (106) in gleichem Abstand zueinander angeordnet sind und/oder die Öffnungen eine Fläche zwischen 1 µm² und 50 µm², vorzugsweise zwischen 5 µm² und 15 µm², aufweisen.

9. Feldeffekttransistor nach Anspruch 4 oder nach Anspruch 4 und einem der Ansprüche 5 bis 8, wobei die Öffnungen (106) eine rechteckige Form aufweisen.

10. Feldeffekttransistor nach einem der vorangehenden Ansprüche, wobei die Gate-Elektrode (103) eine Gate-Länge (L) zwischen 0,15 µm und 0,7 µm und eine Gate-Breite (W) von über 400 µm aufweist.

11. Feldeffekttransistor nach einem der vorangehenden Ansprüche, wobei der Feldeffekttransistor eine Mehrzahl segmentierter Transistorfinger umfasst, die so angeordnet sind, dass sie einen Array ausbilden, wobei jeder Transistorfinger einen oder mehrere separate Mesabereiche (101), einen oder mehrere separate Source-Anschlüsse (102) und einen oder mehrere separate Drain-Anschlüsse (102) umfasst,
wobei die Source-Anschlüsse (102) und die Drain-Anschlüsse (102) der Transistorfinger von einer Source-Drain-Verbindungsleitung (108) aus elektrisch verbunden sind.

12. Feldeffekttransistor nach den Ansprüchen 4 und 11, wobei sich die Öffnungen (106) im Bereich zwischen den Mesabereichen (101) befinden.

13. Feldeffekttransistor nach Anspruch 4 oder nach Anspruch 4 und einem der Ansprüche 5 bis 12, wobei die Passivierungsschicht (104) eine Dicke von über 200 nm aufweist, um eine niedrige Gate-Drain-Kapazität und eine geringe Gate-Drain-Kopplung bereitzustellen.

14. Feldeffekttransistor nach einem der Ansprüche 11 bis 12 oder nach Anspruch 11 und einem der Ansprüche 12 bis 13, wobei die Gate-Elektroden (103) aufeinander folgender Fingersegmente durch Zwischenpads zwischen den Mesabereichen (101) der aufeinander folgenden Fingersegmente auf isolierendem Substratbereich (100) verbunden sind.

15. Verfahren zur Herstellung eines Feldeffekttransistors, umfassend:
Bereitstellen eines Substrats (100),
Aufbringen einer Halbleiterschicht (100b), eines Source-Anschlusses (102) und eines Drain-Anschlusses (102),
Aufbringen einer länglichen Gate-Elektrode (103) auf der Halbleiterschicht (100b) in einem zwischen dem Source-Anschluss (102) und dem Drain-Anschluss (102) befindlichen Bereich, wobei die Gate-Elektrode (103) ein erstes Ende (109) zum Kontaktieren einer Energiequelle und ein zweites Ende (110) aufweist,
wobei die Gate-Elektrode (103) in einem Bereich zwischen dem ersten Ende (109) und dem zweiten Ende (110) mit einer Feed-plate (107) elektrisch verbunden ist,
wobei die Feed-plate (107) über den Rand der Gate-Elektrode (103) in Richtung des Drain-Anschlusses (102) übersteht und so angepasst ist, dass sie sowohl als Feed-line als auch als Field-plate fungiert.

16. Verfahren nach Anspruch 15, wobei zwischen der Halbleiterschicht (100b) und der Feed-plate (107) eine Passivierungsschicht (104) ausgebildet ist.

17. Verfahren nach Anspruch 16, wobei eine oder mehrere zusätzliche Passivierungsschichten (111) zwischen der Halbleiterschicht (100b) und der Passivierungsschicht (104) auf der Gate-Elektrode (103) aufgebracht sind.

## Revendications

1. Un transistor à effet de champ, comprenant :
un substrat (100), une couche semi-conductrice (100b), un contact source (102) et un contact drain (102) ; la couche semi-conductrice (100b) étant disposée sur le substrat (100), le contact source (102) et le contact drain (102) étant disposés sur la couche semi-conductrice (100b) ; et une électrode grille (103) étant disposée sur la couche semi-conductrice (100b) dans une zone qui est située entre le contact source (102) et
le contact drain (102), l'électrode grille (103) présentant une forme allongée et ayant une première extrémité (109) pour le contact avec une source d'alimentation et une seconde extrémité (110),
**caractérisé par** une plaque d'alimentation (107) connectée de façon électrique à l'électrode grille (103), la plaque d'alimentation (107) étant en contact avec l'électrode grille (103) dans une zone située entre la première extrémité (109) et la seconde extrémité (110), et dépassant au-dessus du bord de l'électrode grille (103) vers le contact drain (102), la plaque d'alimentation (107) étant adaptée afin de faire fonction à la fois de ligne d'alimentation et de plaque de champ.

2. Le transistor à effet de champ selon la revendication 1, la couche semi-conductrice (100b) étant une couche semi-conductrice dopée ou le transistor à effet de champ comprenant au moins une première couche semi-conductrice (100a) non dopée et une seconde couche semi-conductrice (100b) dopée.

3. Le transistor à effet de champ selon la revendication 2, la première couche semi-conductrice (100a) comprenant du GaN et la seconde couche semi-conductrice (100b) comprenant de l'AlGaN.

4. Le transistor à effet de champ selon la revendication 1, une couche de passivation (104) étant disposée sur l'électrode grille (103) et la plaque d'alimentation (107) étant disposée sur la couche de passivation (104) dans la zone située au-dessus de l'électrode grille (103), et la couche de passivation (104) comprenant au moins deux ouvertures (106), l'électrode grille (103) étant en contact avec la plaque d'alimentation (107) par les ouvertures (106).

5. Le transistor à effet de champ selon l'une des revendications précédentes, la plaque d'alimentation (107) étant formée en or.

6. Le transistor à effet de champ selon l'une des revendications précédentes, la plaque d'alimentation (107) étant formée dans un matériau ayant une épaisseur d'au moins 0,5 µm et de préférence de plus de 1 µm.

7. Le transistor à effet de champ selon l'une des revendications précédentes, la couche de passivation (104) comprenant une pluralité d'ouvertures (106).

8. Le transistor à effet de champ selon la revendication 4 ou selon la revendication 4 et l'une des revendications 5 à 7, les ouvertures (106) étant disposées à égale distance les unes des autres et/ou les ouvertures comprenant une surface entre 1 µm² et 50 µm², de préférence entre 5 µm² et 15 µm².

9. Le transistor à effet de champ selon la revendication 4 ou selon la revendication 4 et l'une des revendications 5 à 8, les ouvertures (106) présentant une forme rectangulaire.

10. Le transistor à effet de champ selon l'une des revendications précédentes, l'électrode grille (103) présentant une longueur de grille (L) entre 0,15 µm et 0,7 µm et une largeur de grille (W) de plus de 400 µm.

11. Le transistor à effet de champ selon l'une des revendications précédentes, le transistor à effet de champ comprenant une pluralité de doigts de transistor segmentés disposés afin de former un réseau, chaque doigt de transistor comprenant une ou plus régions mésa (101) séparées, un ou plus contacts sources (102) séparés et un ou plus contacts drains (102) séparés, les contacts sources (102) et les contacts drains (102) des doigts de transistors étant connectés électriquement par une ligne de connexion source/drain (108).

12. Le transistor à effet de champ selon les revendications 4 et 11, les ouvertures (106) étant situées dans la zone entre les régions mésa (101).

13. Le transistor à effet de champ selon la revendication 4 ou selon la revendication 4 et l'une des revendications 5 à 12, la couche de passivation (104) ayant une épaisseur de plus de 200 nm, afin de fournir une faible capacité drain-grille et un faible couplage drain-grille.

14. Le transistor à effet de champ selon l'une des revendications 11 à 12 ou selon la revendication 11 et l'une des revendications 12 à 13, les électrodes grille (103) des segments de doigt successifs étant connectées par des languettes intermédiaires entre les régions mésa (101) des segments de doigts successifs sur la zone de substrat isolant (100).

15. Une méthode pour fabriquer un transistor à effet de champ, comprenant :
fournir un substrat (100),
appliquer une couche semi-conductrice (100b), un contact source (102) et un contact drain (102) ;
appliquer une électrode grille (103) allongée sur la couche semi-conductrice (100b), dans une zone qui est située entre le contact source (102) et le contact drain (102), l'électrode grille (103) ayant une première extrémité (109) pour le contact avec une source d'alimentation et une seconde extrémité (110) ;
l'électrode grille (103) étant connectée électriquement avec une plaque d'alimentation (107) dans une région située entre la première extrémité (109) et la seconde extrémité (110), la plaque d'alimentation (107) dépassant par dessus le bord de l'électrode grille (103) vers le contact drain (102) et étant adaptée afin de faire fonction à la fois de ligne d'alimentation et de plaque d'alimentation.

16. La méthode selon la revendication 15, une couche de passivation (104) étant formée entre la couche semi-conductrice (100b) et la plaque d'alimentation (107).

17. La méthode selon la revendication 16, une ou plusieurs couches de passivation (111) supplémentaires étant appliquées sur le l'électrode grille (103) entre la couche semi-conductrice (100b) et la couche de passivation (104).
